# EUROPEAN PATENT SPECIFICATION

(11) **EP 2 827 694 B1**
(45) Date of publication and mention of the grant of the patent: **24.04.2019**
(21) Application number: 12871124.9
(22) Date of filing: 12.03.2012
(51) Int. Cl.: H05K 13/04, H05K 13/02

(54) **COMPONENT MOUNTING DEVICE**
KOMPONENTENMONTAGEVORRICHTUNG
DISPOSITIF DE MONTAGE DE COMPOSANTS

(43) Date of publication of application: 21.01.2015
(73) Proprietor: FUJI Corporation, Chiryu Aichi (JP)
(72) Inventor: NAGATA, Yoshinori, Chiryu, Aichi, (JP); OSAKI, Satoshi, Chiryu, Aichi, (JP)
(74) Representative: Grünecker Patent- und Rechtsanwälte PartG mbB
(86) International application number: PCT/JP2012/056282
(87) International publication number: WO 2013/136414

(56) References cited:
- JP-A- 2004 311 688
- JP-A- 2007 073 791
- JP-A- 2011 205 021
- US-A1- 2012 146 408

## Description

### Technical Field

The present invention relates to a component mounting apparatus equipped with a plurality of feeders.

### Background Art

In the related art, as described in PTL 1 (Japanese Patent No. 4777209), one component mounting apparatus is equipped with a plurality of feeders and a component supplied from each feeder is mounted on a circuit substrate by picking up the component with a pick-up nozzle. The power is continuously supplied to the plurality of feeders equipped in the component mounting apparatus during operation of the component mounting apparatus and since the component is mounted on the circuit substrate by picking up the component with the pick-up nozzle in order determined by a production job in advance, the plurality of feeders equipped in the component mounting apparatus stop a component supply operation and stand by until the order of pick-up of components comes.

In order to reduce power consumption during a standby period of the feeder, a power supply mode of a motor that is a drive source of the component supply operation of the feeder during the standby period is switched to a power saving mode and the power consumption of the motor is reduced in PTL 1. WO-A-2011/121941 discloses another component mounting apparatus of the prior art.

### Citation List

### Patent Literature

PTL 1: Japanese Patent No. 4777209

### Summary of Invention

### Technical Problem

However, as described in PTL 1, since the power is continuously supplied to a control section of the plurality of feeders equipped in the component mounting apparatus only by switching the power supply mode of the motor to the power saving mode during the standby period of the feeder, power saving effects as an entire component mounting apparatus are reduced. Furthermore, if the power is continuously supplied to the control section of the feeder during the standby period of the feeder, the control section of the feeder is heated, a temperature of air around the feeder increases and air around the feeder is dry, and thereby static electricity is likely to occur. Thus, in the feeder supplying a minute component, the static electricity is charged in a cover tape (top tape) peeled from an upper surface of a component supply tape and thereby the component is likely to stick to the cover tape and failure of the pick-up of the component is likely to occur in the pick-up nozzle. As a countermeasure against the static electricity, it is necessary to suppress drying of the air by suppressing an increase in the temperature around the feeder by providing a cooling fan in a feeder mounting section of the component mounting apparatus or to remove the static electricity around the feeder by providing an ionizer. Therefore, there is a problem that costs for a countermeasure against the static electricity increase.

Thus, an object of the invention to solve the problem is to increase power saving effects of a feeder equipped in a component mounting apparatus and to reduce costs for a countermeasure against the static electricity.

### Solution to Problem

In order to solve the above problem, a component mounting apparatus according to claim 1 is provided.

In this case, when the power supply is turned OFF to the feeder, at least a time required to confirm the turn on of the control section of the feeder and the feeder ID after the power supply is turned ON again until becoming a state where the component supply operation can be started after the power supply is turned ON again is necessary as "operation preparation time after the power supply is turned ON again". In consideration of this point, the invention is configured such that the power supply is turned OFF to the feeder when starting the feeder standby period for the feeder in which the feeder standby period exceeds at least the operation preparation time after the power supply is turned ON again and the power supply is turned ON again to the feeder at timing earlier than when finishing the feeder standby period at least by the operation preparation time after the power supply is turned ON again. Therefore, since the power supply is turned OFF to the feeder during the feeder standby period and the power saving effects can be increased, and heating of the control section of the feeder can be eliminated, it is possible to suppress occurrence of the static electricity by suppressing the drying of the air around the feeder and to reduce the costs for the countermeasure against static electricity. Furthermore, since the power is turned ON again to the feeder at timing earlier than when finishing of the feeder standby period at least by the operation preparation time after the power supply is turned ON again, it is possible to start the component supply operation immediately after the finish of the feeder standby period. Thus, it is possible to execute supply, pick-up, and mounting of the component at timing designated in the production job and productivity is not reduced.

However, when the power supply is turned OFF to the feeder during the feeder standby period, a stop position of the motor that is a drive source of the component supply operation may be deviated by vibration and the like. When a relatively large component is picked up in the pick-up nozzle, since deviation (deviation of the position of the component) of the component supply tape due to the deviation of the stop position of the motor during the feeder standby period does not matter greatly, the component can be stably picked up in the pick-up nozzle, but when a minute component is picked up, influence of the deviation of the component supply tape by the deviation of the stop position of the motor during the feeder standby period is large and it is possible to occur failure of the pick-up of the component.

As a countermeasure thereof, as described in claim 2, the power supply control means may obtain a size or information (for example, a tape width of the component supply tape, a tape feeding pitch, or the like) relating to the size of the component supplied from each feeder and may maintain the power supply switch means in an ON state during the feeder standby period without being turned OFF for the feeder that supplies the component having a size of a predetermined value or less that receives large influence of the deviation of the stop position of the motor during the feeder standby period. In this case, for the feeder that supplies the component having the size of the predetermined value or less, which is largely affected by the deviation of the stop position of the motor during the feeder standby period, it is possible to hold the stop position of the motor of the feeder by supplying power to the feeder during the feeder standby period. It is possible to prevent the position of the component during the feeder standby period from deviating. Thus, it is possible to prevent the failure of the pick-up of the component from occurring.

### Brief Description of Drawings

Fig. 1 is a plan view of a component mounting apparatus in one embodiment of the invention.
Fig. 2 is a block diagram illustrating a relationship of an electrical connection between the component mounting apparatus and a feeder.
Fig. 3 is a timing chart illustrating one example of ON/OFF control of a feeder power supply.
Fig. 4 is a flow chart illustrating flow of a process of an ON/OFF control program of the feeder power supply.

### Description of Embodiments

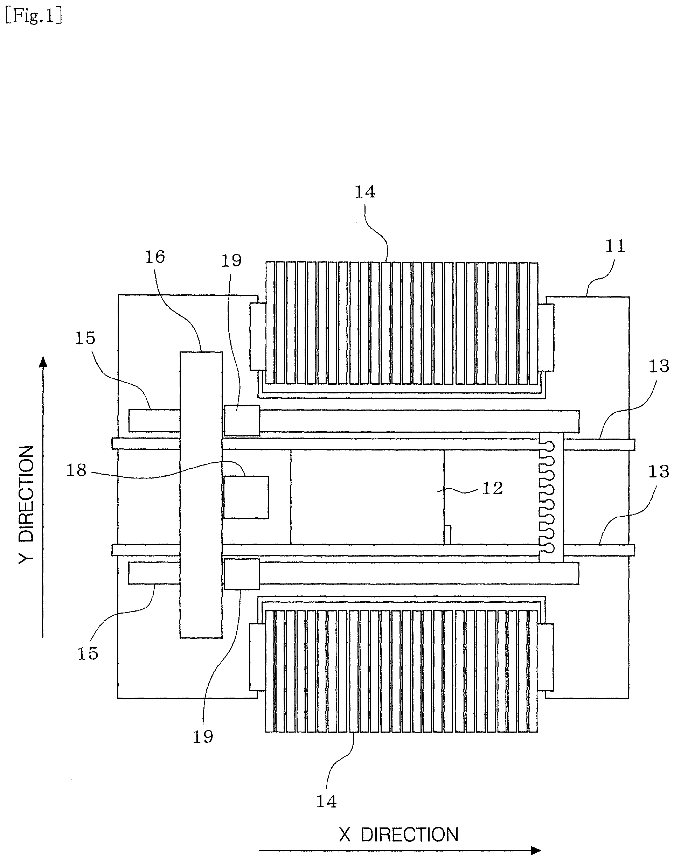

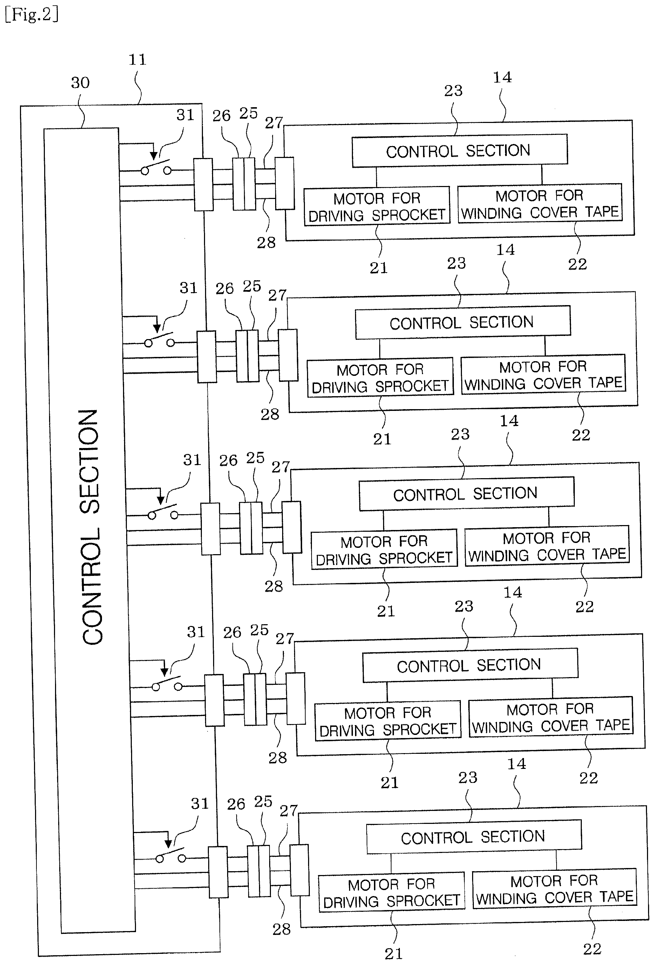

Hereinafter, one embodiment embodying an aspect of the invention will be described. First, a configuration of an entire component mounting apparatus is described with reference to Figs. 1 and 2.

As illustrated in Fig. 1, a component mounting apparatus 11 is provided with a conveyer 13 that transports a circuit substrate 12 in an X direction and a plurality of feeders 14 are arranged respectively on both sides of the conveyer 13. An X slide 16 that moves in a transporting direction (X direction) of the circuit substrate 12 is provided on an X slide base 15 provided parallel to the conveyer 13 and a mounting head 18 is provided in the X slide 16 through a Y slide (not illustrated). A pick-up nozzle (not illustrated) that picks up a component supplied from the feeder 14 is held downward in the mounting head 18. Furthermore, an image capturing section 19 (optical system of a camera) that captures an image of the component picked up to the pick-up nozzle is provided in the X slide 16 and the image capturing section 19 is configured to move in the X direction integrally with the X slide 16.

Each feeder 14 is a tape feeder on which a tape reel is mounted around which the component supply tape is wound, and as illustrated in Fig. 2, is provided with a motor 21 that rotates to drive a sprocket (not illustrated) transporting the component supply tape to a component pick-up position, a motor 22 for winding that peels a cover tape from an upper surface of the component supply tape, and a control section 23 that controls start/stop of each of the motors 21 and 22 and the like. Each of the motors 21 and 22 is configured of a stepping motor, a servo motor, and the like. When mounting each feeder 14 on a feeder set stand (not illustrated) of the component mounting apparatus 11, a connector 25 of each feeder 14 is connected to a connector 26 on the side of the component mounting apparatus 11 and electrical connection is performed between each feeder 14 and the component mounting apparatus 11 with an electrical line 27 and a signal line 28 through the connectors 25 and 26.

The component mounting apparatus 11 is provided with a control section 30 that controls an operation of each section and a plurality of power supply switches 31 (power supply switch means) that turn ON/OFF power supply to each feeder 14 for each feeder 14. A configuration is provided such that the power supply switch 31 of the feeder 14 is mechanically ON and the power supply to the feeder 14 is started by mounting the feeder 14 on the feeder set stand of the component mounting apparatus 11.

The control section 30 of the component mounting apparatus 11 functions as power supply control means for controlling ON/OFF of each power supply switch 31 and also functions as feeder ID confirmation means for confirming identification information (hereinafter, referred to as "feeder ID") of each feeder 14 or a state of each feeder 14 by communicating with the control section 23 of each feeder 14 after turning ON of each power supply switch 31.

Furthermore, the control section 30 of the component mounting apparatus 11 also functions as feeder standby period determination means for determining a standby period (hereinafter, referred to as "feeder standby period") by stopping a component supply operation of each feeder 14 during execution of a production job based on the production job (production program) in which the component supplied from each feeder 14 is mounted on the circuit substrate 12. For a feeder 14 among the plurality of feeders 14 mounted on the component mounting apparatus 11, in which a feeder standby period exceeds an operation preparation time after the power supply is turned ON again T (or slightly longer time than that) (described below), the power supply to the feeder 14 is turned OFF by turning OFF the power supply switch 31 when starting of the feeder standby period and then the power supply is turned ON again to the feeder 14 by turning ON the power supply switch 31 at the timing earlier than when finishing the feeder standby period by the operation preparation time after the power supply is turned ON again T (or slightly longer time than that) . In this case, the operation preparation time after the power supply is turned ON again T is a time required to confirm turn on of the control section 23 of the feeder 14 and the feeder ID after the power supply is turned ON again and a time required for the feeder 14 to become a state of being capable of starting the component supply operation after the power supply is turned ON again.

However, when turning OFF the power supply to the feeder 14 during the feeder standby period, a stop position of the motor 21 for driving the sprocket that is a drive source of the component supply operation may be deviated by vibration and the like. When a relatively large component is picked up in the pick-up nozzle, since deviation (deviation of the position of the component) of the component supply tape due to the deviation of the stop position of the motor 21 during the feeder standby period does not matter greatly, the component can be stably picked up in the pick-up nozzle, but when a minute component is picked up, influence of the deviation of the component supply tape by the deviation of the stop position of the motor 21 during the feeder standby period is large and it is possible to occur failure of the pick-up of the component.

As a countermeasure thereof, in the embodiment, the control section 30 of the component mounting apparatus 11 obtains a size or information (for example, a tape width of the component supply tape, a tape feeding pitch, or the like) relating to the size of the component supplied from each feeder 14 (or obtains component data corresponding to the feeder ID from a component data base stored in a storage device of the control section 30) by communicating with the control section 23 of each feeder 14 and maintains the power supply switch 31 in an ON state during the feeder standby period without being turned OFF for the feeder 14 that supplies the component having a size of a predetermined value or less that is largely affected by the deviation of the stop position of the motor 21 during the feeder standby period, and then the power supply to the motor 21 is continued. In this case, for the feeder 14 that supplies the component having the size of the predetermined value or less, which is largely affected by the deviation of the stop position of the motor 21 during the feeder standby period, it is possible to hold the stop position of the motor 21 of the feeder 14 by supplying power to the feeder 14 during the feeder standby period. It is possible to prevent the position of the component supply tape during the feeder standby period from deviating. Thus, it is possible to prevent the failure of the pick-up of the component from occurring.

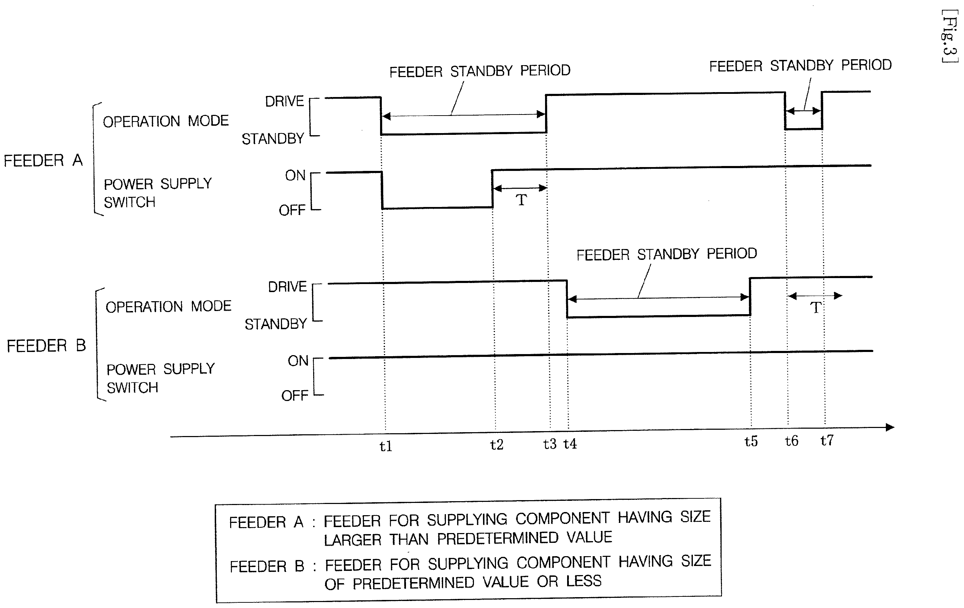

One example of the ON/OFF control of the power supply of the feeder 14 of the embodiment described above will be described with reference to a timing chart of Fig. 3. In Fig. 3, a feeder A is the feeder 14 that supplies the component which is unlikely to be affected by the deviation of the stop position of the motor 21 during the feeder standby period and which has a size larger than a predetermined value and a feeder B is the feeder 14 that supplies the component which is likely to be affected by the deviation of the stop position of the motor 21 during the feeder standby period and which has a size of a predetermined value or less.

For the feeder A that supplies the component having the size larger than the predetermined value, it is determined whether or not the feeder standby period exceeds the operation preparation time after the power supply is turned ON again T (or slightly longer time than that) before the next feeder standby period arrives and if it is determined that the feeder standby period exceeds the operation preparation time after the power supply is turned ON again T (or slightly longer time than that), the power supply switch 31 of the feeder A is turned OFF and the power supply to the feeder A is turned OFF at a starting time t1 of the feeder standby period. Therefore, the power supply switch 31 of the feeder A is turned ON and the power supply is turned ON again to the feeder A at timing t2 earlier than a finish time t3 of the feeder standby period by the operation preparation time after the power supply is turned ON again T (or slightly longer time than that). Therefore, the feeder A returns to a state of being capable of starting the component supply operation by the time the feeder standby period is finished and the component supply operation is started immediately after the feeder standby period is finished.

On the other hand, for the feeder standby period of t6 to t7 of Fig. 3, it is determined that the feeder standby period does not exceed the operation preparation time after the power supply is turned ON again T (or slightly longer time than that) and the power supply switch 31 of the feeder A is not turned OFF even during the feeder standby period and the power supply to the feeder A is continued.

On the other hand, for the feeder B that supplies the component having the size of the predetermined value or less, even when the feeder standby period of t4 to t5 of Fig. 3 exceeds the operation preparation time after the power supply is turned ON again T (or slightly longer time than that), the power supply switch 31 of the feeder B is maintained in the ON state and the power supply to the feeder B is continued. Therefore, the motor 21 for driving the sprocket is maintained in the stop position during the feeder standby period and the position of the component supply tape is prevented from deviating. Next, power saving effects by turning OFF the power supply to the feeder 14 during the feeder standby period will be described.

For example, when power consumption of the control section 23 of the feeder 14 is 600 [mW] and the power consumption of each of the motors 21 and 22 during stop of the component supply operation is 600 [mW], respectively, the power of a total 1800 [mW] is consumed even during stop of the component supply operation for each of the feeders 14. If the power supply is turned OFF to N feeders 14 among the plurality of feeders 14 mounted on the component mounting apparatus 11, it is possible to save the power consumption of a total 1800×N [mW] and it is possible to obtain greater power saving effects.

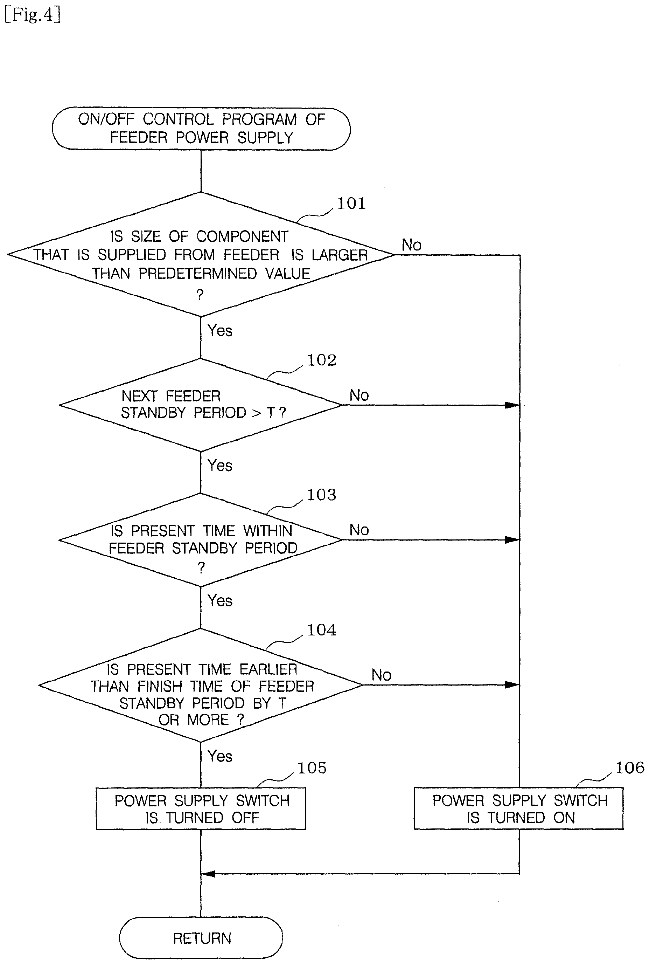

The ON/OFF control of the power supply of the feeder 14 of the embodiment described above is executed in the following process according to the ON/OFF control program of the feeder power supply of Fig. 4 by the control section 30 of the component mounting apparatus 11. The ON/OFF control program of the feeder power supply of Fig. 4 is executed repeatedly in a predetermined period for each feeder 14 mounted on the component mounting apparatus 11 and serves as the power supply control means that is referred to in the claims.

When starting the program, first, in step 101, it is determined whether or not the size of the component that is supplied from the feeder 14 is larger than a predetermined value and if it is determined that the size is the predetermined value or less, the process proceeds to step 106 and the power supply switch 31 of the feeder 14 is maintained in the ON state, and then the program is completed.

On the other hand, in the step 101, it is determined that the size of the component that is supplied from the feeder 14 is larger than the predetermined value, the process proceeds to step 102 and it is determined whether or not the next feeder standby period is longer than the operation preparation time after the power supply is turned ON again T (or slightly longer time than that) . If it is determined that the feeder standby period is shorter than the operation preparation time after the power supply is turned ON again T (or slightly longer time than that), the process proceeds to step 106 and the power supply switch 31 of the feeder 14 is maintained or is switched to the ON state, and then the program is completed.

In the step 102, if it is determined that the next feeder standby period is longer than the operation preparation time after the power supply is turned ON again T (or slightly longer time than that), the process proceeds to step 103 and it is determined whether or not the present time is within the feeder standby period, and if it is determined that the present time is not within the feeder standby period, the process proceeds to step 106, and the power supply switch 31 of the feeder 14 is maintained or is switched to the ON state, and then the program is completed.

In the step 103, if it is determined that the present time is within the feeder standby period, the process proceeds to step 104 and it is determined whether or not the present time is earlier than the finish time of the feeder standby period by the operation preparation time after the power supply is turned ON again T (or slightly longer time than that) or more. As a result, if it is determined that the present time is earlier than the finish time of the feeder standby period by the operation preparation time after the power supply is turned ON again T (or slightly longer time than that), the process proceeds to step 105 and the power supply switch 31 of the feeder 14 is maintained or is switched to the OFF state, and then the program is completed.

Therefore, at a time point when the present time reaches timing earlier than the finish time of the feeder standby period by the operation preparation time after the power supply is turned ON again T (or slightly longer time than that), "No" is determined in the step 104 and the process proceeds the step 106 and the power supply switch 31 of the feeder 14 is maintained or is switched to the ON state, and then the program is completed.

According to the embodiment described above, for the feeder 14 in which the feeder standby period exceeds the operation preparation time after the power supply is turned ON again T (or slightly longer time than that), the power supply to the feeder 14 is turned OFF when starting the feeder standby period and then the power supply to the feeder 14 is turned ON again at the timing earlier than the finish time of the feeder standby period by the operation preparation time after the power supply is turned ON again T (or slightly longer time than that). Therefore, since the power saving effects can be increased and heating of the control section 23 of the feeder 14 can be eliminated by turning OFF the power supply to the feeder 14 during the feeder standby period, it is possible to suppress occurrence of the static electricity by suppressing the drying of the air around the feeder 14 and to reduce the costs for the countermeasure against static electricity. Furthermore, since the power supply is turned ON again to the feeder 14 at timing earlier than when finishing of the feeder standby period by the operation preparation time after the power supply is turned ON again T (or slightly longer time than that), it is possible to start the component supply operation immediately after the finish of the feeder standby period. Thus, it is possible to execute supply, pick-up, and mounting of the component at timing designated in the production job and productivity is not reduced.

Furthermore, the component mounting apparatus 11 of the embodiment is configured such that the plurality of feeders 14 are arranged on both sides of the conveyer 13, respectively, but the component mounting apparatus 11 of the embodiment is configured such that the plurality of feeders 14 may be arranged only on one side of the conveyer 13.

Furthermore, the plurality of feeders 14 mounted on the component mounting apparatus 11 are not limited to only the tape feeders and a part of or all of the plurality of feeders 14 mounted on the component mounting apparatus 11 may be changed to a feeder (for example, a bulk feeder, a stick feeder, a tray feeder, and the like) other than the tape feeder.

### Reference Signs List

11...component mounting apparatus, 12...circuit substrate, 13...conveyor, 14...feeder, 18...mounting head, 21...motor for driving sprocket, 22...motor for winding cover tape, 23...control section of feeder, 25 and 26...connector, 27...power supply line, 28...signal line, 30...control section of component mounting apparatus (power supply control means, feeder ID confirmation means), 31...power supply switch (power supply switch means)

## Claims

1. A component mounting apparatus (11) equipped with a plurality of feeders (14) comprising:
a plurality of power supply switch means (31) for turning ON/OFF of a power supply to the plurality of feeders (14) for each feeder (14) and power supply control means (30) for controlling ON/OFF of each of the power supply switch means (31), **characterised in that** it further comprises:
feeder ID confirmation means (30) for confirming identification information of each feeder (14) by communicating with a control section (23) of each feeder (14) after each of the power supply switch means (31) is turned ON;
feeder standby period determination means (30) for determining a feeder standby period by stopping a component supply operation of each feeder (14) during execution of a production job based on the production job for mounting components supplied from the plurality of feeders (14) on a circuit substrate (12),
wherein the power supply control means (30) turns OFF the power supply switch means (31) of a feeder (14) among the plurality of feeders (14), when starting the feeder standby period for the feeder (14) in a case in which the feeder standby period of the respective feeder (14) exceeds at least a predetermined operation preparation time (T) corresponding to a time required to confirm ON-status of the control section (23) of the feeder (14) and the identification information of the feeder (14) after the power supply has been turned ON, and wherein the power supply control means (30) turns ON the power supply switch means (31) at a timing which is earlier than the end of the feeder standby period at least by the predetermined operation preparation time (T).

2. The component mounting apparatus (11) according to claim 1, wherein the power supply control means (30) obtains a size or information relating to the size of the component supplied from each feeder (14) and maintains the power supply switch means (31) in an ON state during the feeder standby period without being turned OFF for the feeder (14) that supplies the component having a size of a predetermined value or less.

## Patentansprüche

1. Ein Komponentenbestückungsapparat (11) ausgerüstet mit einer Vielzahl von Zuführern (14) umfassend:
eine Vielzahl von Leistungsversorgungsschalteinrichtungen (31) zum EIN/AUS-Schalten einer Leistungszufuhr zu den mehreren Zuführern (14) für jeden Zuführer (14) und Leistungsversorgungssteuereinrichtungen (30) zum EIN/AUS Steuern jeder der Leistungsversorgungsschalteinrichtungen (31), **dadurch gekennzeichnet, dass** er ferner umfasst:
Zuführer-ID-Bestätigungseinrichtung (30) zum Bestätigen von Identifikationsinformationen von jedem Zuführer (14) durch Kommunizieren mit einem Steuerabschnitt (23) mit jedem Zuführer (14), nachdem jede der Leistungsversorgungsschalteinrichtungen (31) eingeschaltet ist;
eine Zuführungs-Standbydauer-Bestimmungseinrichtung (30) zum Bestimmen einer Zuführer Standbydauer durch Stoppen eines Komponentenzuführvorgangs jedes Zuführers (14) während der Ausführung eines Produktionsauftrages basierend auf dem Produktionsauftrag zum Anbringen von Komponenten, die von der Vielzahl von Zuführern (14) auf einen Schaltungsträger (12) zugeführt werden,
wobei die Leistungsversorgungssteuereinrichtung (30) die Leistungsversorgungsschalteinrichtung (31) eines Zuführers (14) aus der Vielzahl von Zuführern (14) ausschaltet, wenn die Standbydauer des Zuführers (14) in einem Fall startet, in dem die Zuführer-Standbydauer des jeweiligen Zuführers (14) mindestens eine vorbestimmte Betriebsvorbereitungszeit (T) überschreitet, die einer Zeit entspricht, die zum Bestätigen des EIN-Status des Steuerabschnitts (23) des Zuführers (14) und der Informationsidentifikation des Zuführers (14) erforderlich ist, nachdem die Leistungsversorgung eingeschaltet wurde, und wobei die Leistungsversorgungssteuereinrichtung (30) die Leistungsversorgungsschalteinrichtungen (31) zu einem Zeitpunkt einschaltet, der mindestens um die vorbestimmte Betriebsvorbereitungszeit (T) vor dem Ende der Zuführer-Standbydauer liegt.

2. Der Komponentenbestückungsapparat (11) gemäß Anspruch 1, wobei
die Leistungsversorgungssteuereinrichtung (30) eine Größe oder Information erhält die sich auf die Größe der von jedem Zuführer (14) zugeführten Komponente bezieht und die Leistungsversorgungsschalteinrichtung (31) während der Zuführer-Standbydauer in einem EIN-Zustand hält, ohne für den Zuführer (14) ausgeschaltet zu werden, der die Komponente mit einer Größe eines vorbestimmten Werts oder darunter zuführt.

## Revendications

1. Appareil de montage de composants (11) équipé d'une pluralité de dispositifs d'alimentation (14) comprenant:
une pluralité de moyens de commutation d'alimentation (31) destinés à mettre sous tension/hors tension la pluralité de dispositifs d'alimentation (14) pour chaque dispositif d'alimentation (14) et des moyens de commande d'alimentation (30) pour commander mettre sous tension/hors tension chacun des moyens de commutation d'alimentation électrique (31), **caractérisé en ce qu'**il comprend en outre:
un moyen de confirmation d'identification de dispositif d'alimentation (30) pour confirmer les informations d'identification de chaque dispositif d'alimentation (14) en communiquant avec une section de commande (23) de chaque dispositif d'alimentation (14) après la mise en marche de chacun des moyens de commutation d'alimentation (31);
un moyen de détermination de période d'attente de dispositif d'alimentation (30) pour déterminer une période d'attente d'alimentation en arrêtant une opération d'alimentation en composants de chaque dispositif d'alimentation (14) pendant l'exécution d'un travail de production sur la base du travail de production pour le montage de composants alimentés à partir de la pluralité de dispositifs d'alimentation (14) sur un substrat de circuit (12),
dans laquelle le moyen de commande d'alimentation (30) éteint le moyen de commutation d'alimentation (31) d'un dispositif d'alimentation (14) parmi la pluralité de dispositifs d'alimentation (14), lors du démarrage de la période de veille du dispositif d'alimentation (14) dans un cas dans lequel la période de veille du dispositif d'alimentation respectif (14) dépasse au moins un temps de préparation au fonctionnement prédéterminé (T) correspondant à un temps nécessaire pour confirmer l'état sous tension de la section de commande (23) du dispositif d'alimentation (14) et les informations d'identification du dispositif d'alimentation (14) après la mise sous tension de l'alimentation, et dans lequel le moyen de commande d'alimentation (30) met en marche le moyen de commutation d'alimentation (31) à un instant qui est antérieur à la fin de la période d'attente du dispositif d'alimentation au moins jusqu'au temps de préparation de fonctionnement prédéterminé (T).

2. Appareil de montage de composants (11) selon la revendication 1, dans lequel le moyen de commande d'alimentation (30) obtient une taille ou une information relative à la taille du composant alimenté par chaque dispositif d'alimentation (14) et maintient le moyen de commutation d'alimentation (31) sous tension pendant la période de veille du dispositif d'alimentation sans être mis hors tension pour le dispositif d'alimentation (14) qui alimente le composant ayant une taille d'une valeur prédéterminée ou inférieure.
